# EUROPEAN PATENT APPLICATION

(11) **EP 3 376 490 A1**
(43) Date of publication of application: **19.09.2018**
(21) Application number: 15908147.0
(22) Date of filing: 18.12.2015
(51) Int. Cl.: G09B 5/04

(54) **TOUCH-SENSING SOUND PRODUCTION INTERACTIVE PLATFORM AND RECOGNIZING METHOD THEREOF**

(30) Priority: 11.11.2015 CN 201510771546
(71) Applicant: Leo Paper Bags Manufacturing (1982) Limited, Hong Kong (CN); Heshan Astros Printing Ltd., Heshan, Guangdong 529700 (CN)
(72) Inventor: LAM, Cannie, Hong Kong (CN); YEUNG, Daniel, Hong Kong (CN)
(74) Representative: Delorme, Nicolas
(86) International application number: PCT/CN2015/097872
(87) International publication number: WO 2017/080017

(57) **Abstract**

The present invention discloses a touch sensing interactive audio platform and a recognition method thereof, comprising a sensing circuit board and a main control board. The sensing circuit board is provided with a touch sensing board used for sensing a touch area and the touch sequence, the touch sensing board is provided with one or more touch sensing areas, the main control board comprises a main control chip, a speaker, and a power supply unit, and the main control chip is connected to the touch sensing area, the speaker, and the power supply unit respectively. Patterns and characters can be identified by slightly sliding through the touch sensing area with a finger according to the present invention, which is convenient and effort-saving; a thicker rigid printed circuit board is replaced with a thinner sensing circuit board according to the present invention to make the product lighter and thinner; and the card used in the present invention has no embedded chip or voice device, so the card is lighter and thinner than a jigsaw card with an embedded or voice device, and is easy to make, use and store. Different chips can be used for different outputs in the present invention, which comprise but are not limited to light, pictures, motion images or action.

## Description

### TECHNICAL FIELD

The present invention relates to an interactive audio platform and a recognition method thereof, and more particularly, to a touch sensing interactive audio platform and a recognition method thereof.

### BACKGROUND

Electronic audio reading materials are educational reading materials that can help children develop their visual, auditive and practical abilities, and enables children to listen to corresponding sounds or music by placing or touching different cards or tags. Thereby, the reading material can be more appealing to children with interactivity, breaking boring way of learning, both of which make children's education more entertaining. The technical product has a simple structure and is convenient to use, which uses pleasing music or attractive content to cultivate children's good behavior and habits, and is especially suitable for child use.

Electronic audio books come in many different types and sizes on the market today, but existing products on the market have the following shortcomings. Firstly, they typically use conventional electronic components such as rigid printed circuit boards, wires, and metal domes (commonly known as snap domes). The metal dome serves as a switch that provides firm electrical contact and excellent feel to the touch. However, it will be difficult for younger children to make a certain amount of effort to depress the metal dome-based switches. Secondly, the rigid printed circuit board below the metal dome is usually comparatively thick and demanding on installation space, thus it further limits the applicability of the product. Thirdly, existing audio jigsaw puzzle e-books on the market are typically operated on this following principle: audio or coded chips are embedded within the pieces of the jigsaw puzzle. When the pieces are placed in their respective recess positions in the book, with conductive contacts, data from the embedded chips inside the pieces is read, and corresponding audio is replayed. To protect the embedded chips from damage, the puzzle pieces must be of an adequate thickness, which increases the cost and makes the pieces cumbersome, raising inconveniences in use.

### SUMMARY

In order to solve the problems above, the present invention aims at providing a touch sensing interactive audio platform and a recognition method thereof.

The technical solutions used in the present invention to solve the problems thereof are as follows: a touch sensing interactive audio platform, comprising a sensing circuit board and a main control board, wherein the sensing circuit board is provided with a touch sensing board used for sensing a touch area and touch sequence, the touch sensing board is provided with one or more touch sensing areas, the main control board comprises a main control chip, a speaker, and a power supply unit, and the main control chip is connected to the touch sensing area, the speaker, and the power supply unit respectively.

Further, the sensing circuit board and the main control board are installed in a book body.

Further, the book body is provided with a recess, and the touch sensing board is arranged in the recess.

Further, the touch sensing board is detachably installed on the sensing circuit board.

Further, the touch sensing interactive audio platform comprises a card printed with an indicating arrow and an identification point, wherein the identification point on the card is one-to-one correspondent with the touch sensing areas on the touch sensing board.

Further, a shape of the touch sensing area can be but is not limited to a circle, a sector, a ring or a polygon.

Further, the sensing circuit board and the main control board are installed in a toy object.

Further, the toy object comprises a housing, and a surface of the housing is provided with one or more touch sensing areas.

Further, the touch sensing interactive audio platform further comprises a a touch film printed with an indicating arrow and an identification point, wherein the touch film is attached to the surface of the housing.

Further, the identification point on the touch film is one-to-one correspondent with the touch sensing areas on the surface of the housing.

Further, the main control chip is preloaded with a program corresponding to the code of each touch sensing area.

A recognition method applied to the touch sensing interactive audio platform, wherein assigning a separate and independent code to each of the touch sensing areas respectively; placing the card matching the shape and size of the recess into the recess, when corresponding contents are read; sliding with a finger on the card according to the indication on the card, wherein the capacitance of corresponding touch sensing area changes when the finger slides within the touch sensing area; finding out a corresponding number by the main control chip according to the touch sensing area where capacitance change occurs; after all the finger slidings are completed, sending a corresponding command by the main control chip to the speaker according to all numbers found out and the sequences thereof; and producing a sound by the speaker corresponding to the contents on the card in the recess after receiving the command.

Further, the contents on the card can be but are not limited to letters of the English alphabet, Chinese characters, numbers or patterns.

Further, the shape of the card can be but is not limited to a circle, a sector, or a polygon.

The present invention has the beneficial effects that: according to the touch sensing interactive audio platform and the recognition method thereof according to the present invention, the touch sensing interactive audio platform comprises the sensing circuit board and the main control board, wherein the sensing circuit board is provided with the touch sensing board used for sensing the touch area and the touch sequence, the touch sensing board is provided with one or more touch sensing areas, the main control board comprises the main control chip, the speaker, and the power supply unit, and the main control chip is connected to the touch sensing area, the speaker, and the power supply unit respectively. The recognition method applied to the touch sensing interactive audio platform is as follows: assigning a separate and independent code to each of the touch sensing areas respectively; placing the card matching the shape and size of the recess into the recess, when corresponding contents are read; sliding with a finger on the card according to the indication on the card, wherein the capacitance of corresponding touch sensing area changes when the finger slides within the touch sensing area; finding out a corresponding number by the main control chip according to the touch sensing area where capacitance change occurs; after all the finger slidings are completed, sending a corresponding command by the main control chip to the speaker according to all numbers found out and the sequences thereof; and producing a sound by the speaker corresponding to the contents on the card in the recess after receiving the command. Patterns and characters can be recognized by slightly sliding through the touch sensing area with a finger according to the present invention, which is convenient and demands relatively little effort; a thinner sensing circuit board is adopted in the present invention as a replacement for a thicker, rigid printed circuit board, which makes the product thinner and more lightweight; and since no chip or audio device is embedded in the cards, the cards are lighter and thinner than a jigsaw piece with embedded chips or audio device, such cards facilitate manufacturing, use and storage. Different chips can be used for different outputs in the present invention, which outputs may comprise but are not limited to light, picture, motion image or action.

### BRIEF DESCRIPTION OF THE DRAWINGS

The present invention is further described hereinafter with reference to the drawings and the embodiments.
Fig. 1 is a structural diagram of the present invention;
Fig. 2 is a diagram of the card in the present invention;
Fig. 3 is a schematic diagram illustrating the arrangement of touch sensing areas of the present invention;
Fig. 4 is a structural diagram of the first embodiment of the present invention; and
Fig. 5 is a structural diagram of the second embodiment of the present invention.

### DETAILED DESCRIPTION

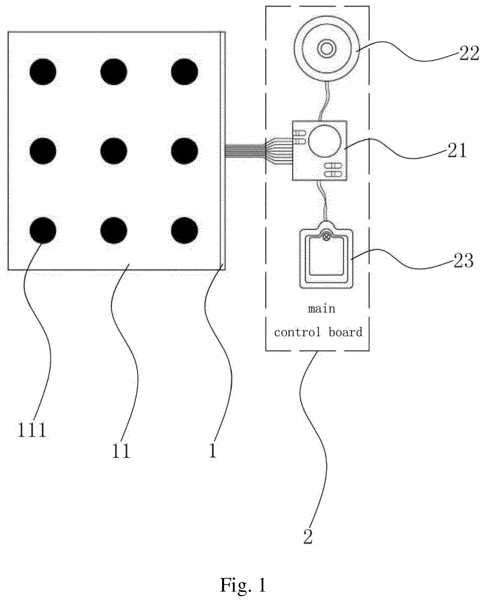

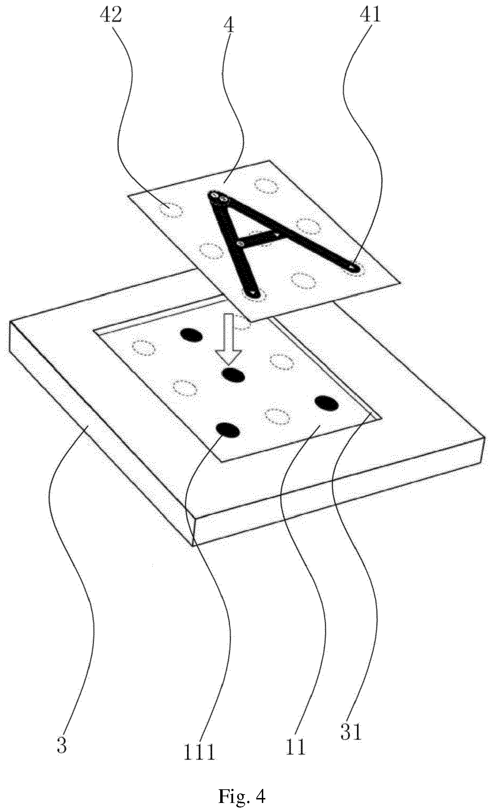

Referring to Fig. 1 and Fig. 4, a touch sensing interactive audio platform of the present invention comprises a sensing circuit board 1 and a main control board 2, wherein the sensing circuit board 1 is provided with a touch sensing board 11 used for sensing a touch area and the touch sequence, the touch sensing board 11 is provided with one or more touch sensing areas 111, the main control board 2 comprises a main control chip 21, a speaker 22, and a power supply unit 23, and the main control chip 21 is connected to the touch sensing area 111, the speaker 22, and the power supply unit 23 respectively.

Advantageously, the sensing circuit board 1 and the main control board 2 are installed in a book body 3.

Advantageously, the book body 3 is provided with a recess 31, and the touch sensing board 11 is arranged in the recess 31.

Advantageously, the touch sensing board 11 is detachably installed on the sensing circuit board 1.

Advantageously, the touch sensing interactive audio platform further comprises a card 4 printed with an indicating arrow 41 and an identification point 42, wherein the identification point 42 on the card 4 is one-to-one correspondent with the touch sensing areas 111 on the touch sensing board 11.

Advantageously, a shape of the touch sensing area 111 can be but is not limited to a circle, a circular sector, a ring or a polygon.

Advantageously, the sensing circuit board 1 and the main control board 2 are installed in a toy object 5.

Advantageously, the toy object 5 comprises a housing 51, and a surface of the housing 51 is provided with one or more touch sensing areas 111.

Advantageously, the touch sensing interactive audio platform further comprises a touch film 52 printed with an indicating arrow 41 and an identification point, wherein the touch film 52 is attached to the surface of the housing 51.

Advantageously, the identification point 42 on the touch film 52 is one-to-one correspondent with the touch sensing areas 111 on the surface of the housing.

Advantageously, the main control chip 21 is preloaded with a program corresponding to the codes of each touch sensing area 111.

A recognition method applied to the touch sensing interactive audio platform is as follows: each of the touch sensing areas 111 respectively has a separate and independent code, when corresponding contents are read, the card 4 matched with a shape and a size of the recess 31 is placed into the same, then a finger slides on the card 4 according to the indication on the card 4, when the finger slides in the touch sensing area 111, a capacitance of corresponding touch sensing area 111 changes, the main control chip 21 finds out a corresponding number accordingly, after all the finger sliding is completed, the main control chip 21 sends a corresponding command to the speaker 22 according to all numbers found out and number sequences, and the speaker 22 produces a sound corresponding to the contents on the card 4 in the recess 31 after receiving the command.

Advantageously, the contents on the card 4 can be but are not limited to letters in the English alphabet, Chinese characters, numbers or a patterns.

Advantageously, the shape of the card 4 can be but is not limited to a circle, a sector, or a polygon.

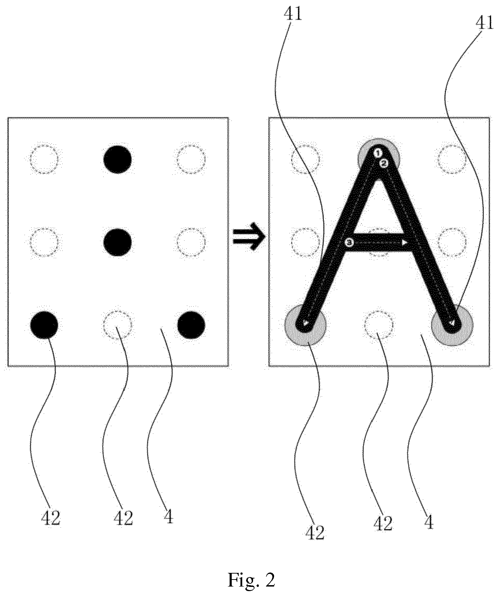

Referring to Fig. 2, in addition to letters of the English alphabet, Chinese characters, numbers or patterns, the card 4 is also provided with a number and the indicating arrow 41 to guide the user, and is further provided with the identification point 42 one-to-one correspondent with the touch sensing areas 111.

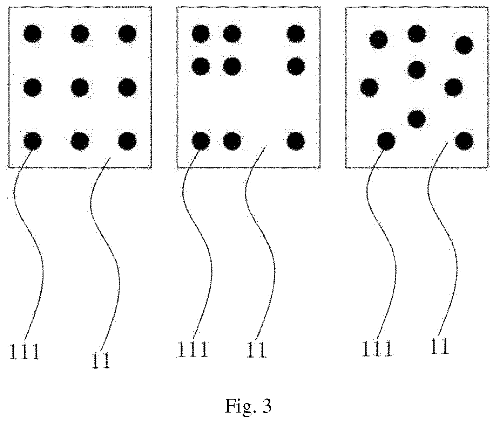

Referring to Fig. 3, the touch sensing areas 111 on the touch sensing board 11 can be configured in more than one manner, including but not limited to matrices, random arrangement or other patterns.

Referring to Fig. 4, when a carrier of the present invention is the book body 3, the shape and size of the card 4 are matched with the of the recess 31, and the identification point 42 on the card 4 is one-to-one correspondent with the touch sensing areas 111 in the recess 31.

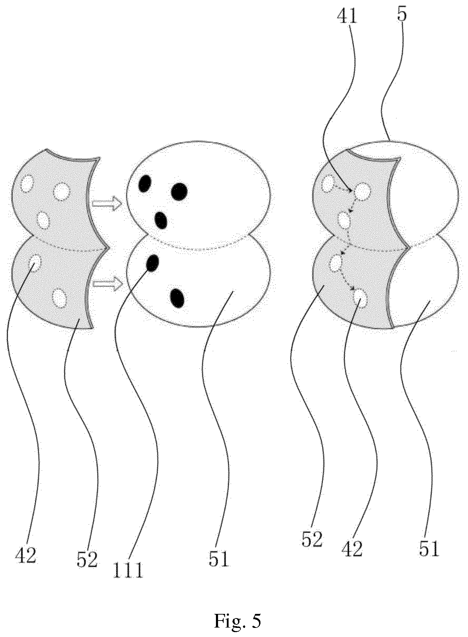

Referring to Fig. 5, besides the book body 3, the carrier of the present invention can also be but is not limited to the toy object 5 or other items in daily life; and the present invention not only can be applied to a flat surface, but can also be but not limited to be applied to a cambered surface or an irregular surface. As shown in the drawings, the toy object 5 is internally provided with the sensing circuit board 1 and the main control board 2, the toy object 5 comprises the housing 51 and the touch film 52, the surface of the housing 51 is provided with the touch sensing areas 111, the touch film 52 is printed with the indicating arrow 41 and the identification point 42, the touch film is attached to the housing 51, the identification point 42 is one-to-one correspondent with the touch sensing areas 111 on the housing 51, and when a finger gently slides on the corresponding area of the touch film 52 following the indication arrow 41 and the identification point, an electronic device can identify the sliding and output (not limited to) sound, motion, light, etc. in accordance with the preloaded program.

The descriptions above are only preferred embodiments of the present invention, but the present invention is not limited to the embodiments above, and the similar means achieving the technical effect of the present invention shall fall in the protection scope of the present invention.

## Claims

1. A touch sensing interactive audio platform, **characterized in that** it comprises a sensing circuit board (1) and a main control board (2), wherein the sensing circuit board (1) is provided with a touch sensing board (11) used for sensing a touch area and touch sequence, the touch sensing board (11) is provided with one or more touch sensing areas (111), the main control board (2) comprises a main control chip (21), a speaker (22), and a power supply unit (23), and the main control chip (21) is connected to the touch sensing area (111), the speaker (22), and the power supply unit (23) respectively.

2. The touch sensing interactive audio platform according to claim 1, **characterized in that** the sensing circuit board (1) and the main control board (2) are installed in a book body (3).

3. The touch sensing interactive audio platform according to claim 2, **characterized in that** the book body (3) is provided with a recess (31), and the touch sensing board (11) is arranged in the recess (31).

4. The touch sensing interactive audio platform according to claim 1, **characterized in that** it further comprises a card (4) printed with an indicating arrow (41) and an identification point (42), wherein the identification point (42) on the card (4) is one-to-one correspondent with the touch sensing areas (111) on the touch sensing board (11).

5. The touch sensing interactive audio platform according to any one of claims 1 or 4, **characterized in that** a shape of the touch sensing area (111) is a circle, a sector, a ring or a polygon.

6. The touch sensing interactive audio platform according to claim 1, **characterized in that** the sensing circuit board (1) and the main control board (2) are installed in a toy object (5).

7. The touch sensing interactive audio platform according to claim 6, **characterized in that** the toy object (5) comprises a housing (51), and a surface of the housing (51) is provided with one or more touch sensing areas (111).

8. The touch sensing interactive audio platform according to claim 7, **characterized in that** it further comprises a touch film (52) printed with an indicating arrow (41) and an identification point, wherein the touch film (52) is attached to the surface of the housing (51).

9. A recognition method applied to the touch sensing interactive audio platform according to any one of claims 1 to 8, **characterized in that**, assigning a separate and independent code to each of the touch sensing areas (111) respectively; placing the card (4) matching the shape and size of the recess (31) into the recess (31), when corresponding contents are read; sliding with a finger on the card (4) according to the indication on the card (4), wherein the capacitance of corresponding touch sensing area (111) changes when the finger slides within the touch sensing area (111); finding out a corresponding number by the main control chip (21) according to the touch sensing area (111) where capacitance change occurs; after all the finger slidings are completed, sending a corresponding command by the main control chip (21) to the speaker (22) according to all numbers found out and the sequences thereof; and producing a sound by the speaker (22) corresponding to the contents on the card (4) in the recess (31) after receiving the command.

10. The recognition method applied to the touch sensing interactive audio platform according to claim 9, **characterized in that** the card (4) is set as a circle, a sector, or a polygon.
